# EUROPEAN PATENT APPLICATION

(11) **EP 0 883 188 A1**
(43) Date of publication of application: **09.12.1998**
(21) Application number: 98109637.3
(22) Date of filing: 27.05.1998
(51) Int. Cl.: H01L 27/148

(54) **CCD Solid-state imaging device**

(30) Priority: 03.06.1997 JP 145010/97
(71) Applicant: SONY CORPORATION, Tokyo (JP)
(72) Inventor: Yoshida, Hiroyuki, Shinagawa-ku, Tokyo (JP)
(74) Representative: Müller, Frithjof E., Dipl.-Ing.

(57) **Abstract**

In a solid-state imaging device having channel barriers in a horizontal transfer register to form a small signal transfer channel, the channel barriers are provided only on the output side of the horizontal transfer register beyond its portion corresponding to an effective pixel region of an imaging area. The width of the small signal transfer channel is equal to the width of the horizontal transfer register in a portion most proximate to a charge transfer source, and is decreased to be narrower toward the output side (transfer destination side) up to a horizontal signal output gate, whereby the gate length in the horizontal transfer register is changed to be greater with approach to the output side. The small signal transfer channel is so shaped as to be wider with approach to the output side under the horizontal signal output gate. In this structure, any reduction of the processible charge quantity derived from the existence of the channel barriers can be eliminated, and the transfer efficiency under the horizontal signal output gate can be raised.

## Description

### BACKGROUND OF THE INVENTION

The present invention relates to a CCD solid-state imaging device and, more particularly, to an imaging device having, in a horizontal transfer register, channel barriers for forming a small signal transfer channel.

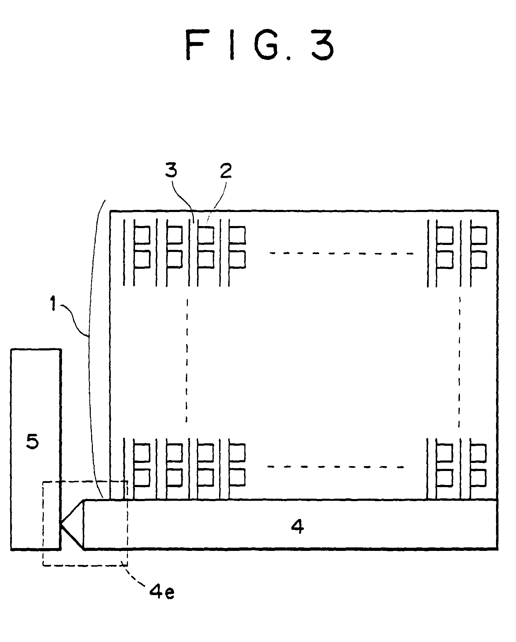

Fig. 3 is a plan view showing an exemplary CCD solid-state imaging device. In this diagram, there are included an effective pixel region 1 of an imaging area, and photo sensors 2 arrayed two-dimensionally in vertical and horizontal directions for storing signal charges corresponding to incident light amounts. Also included are vertical transfer registers 3 provided correspondingly to vertical rows of the photo sensors 2 to vertically transfer the signal charges read out from the photo sensors 2, a horizontal transfer register 4 for horizontally transferring the signal charges transferred vertically from the vertical transfer registers 3, an output part 4e of the horizontal transfer register 4, and a charge detection circuit 5 for detecting the signal charge outputted from the horizontal transfer register 4. This example represents a CCD solid-state imaging device of an interline type. Meanwhile in a CCD solid-state imaging device of a frame interline type, a storage is provided between the effective pixel region 1 and the horizontal transfer register 4.

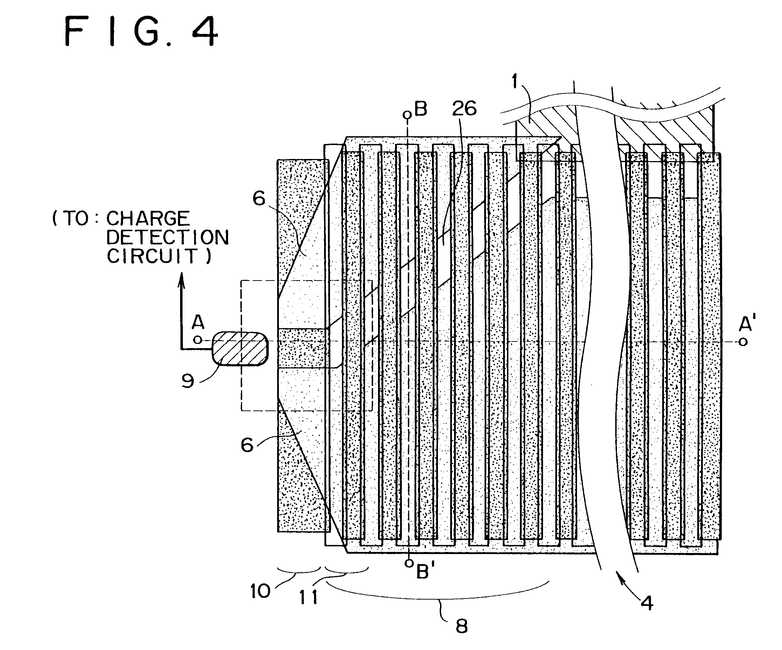

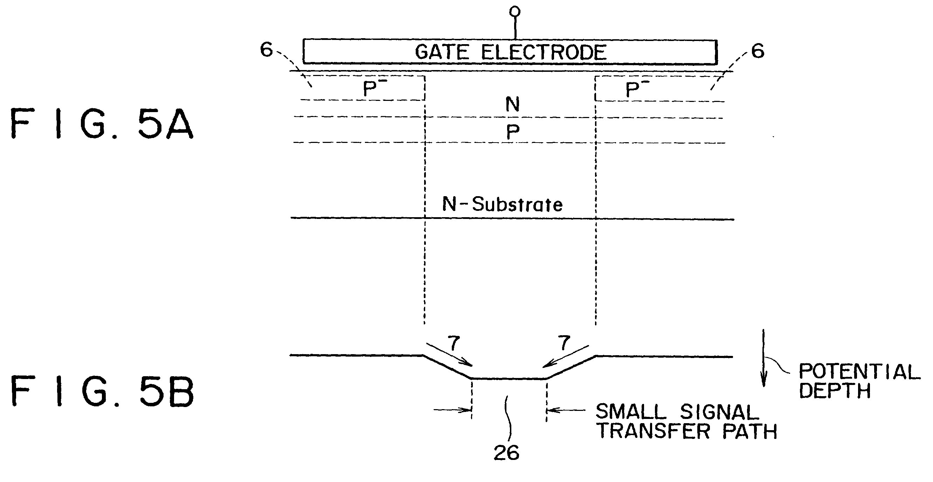

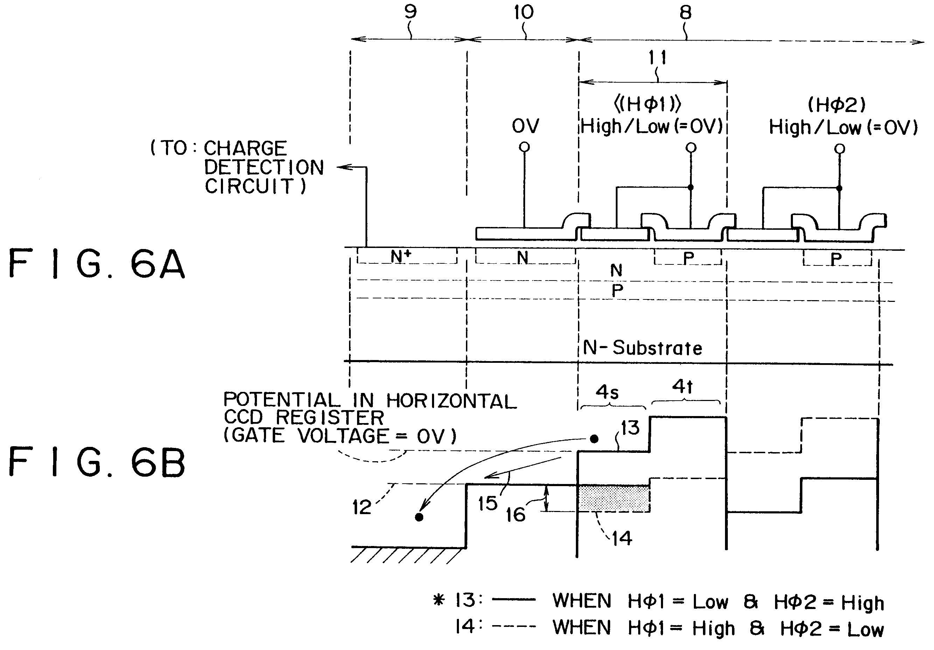

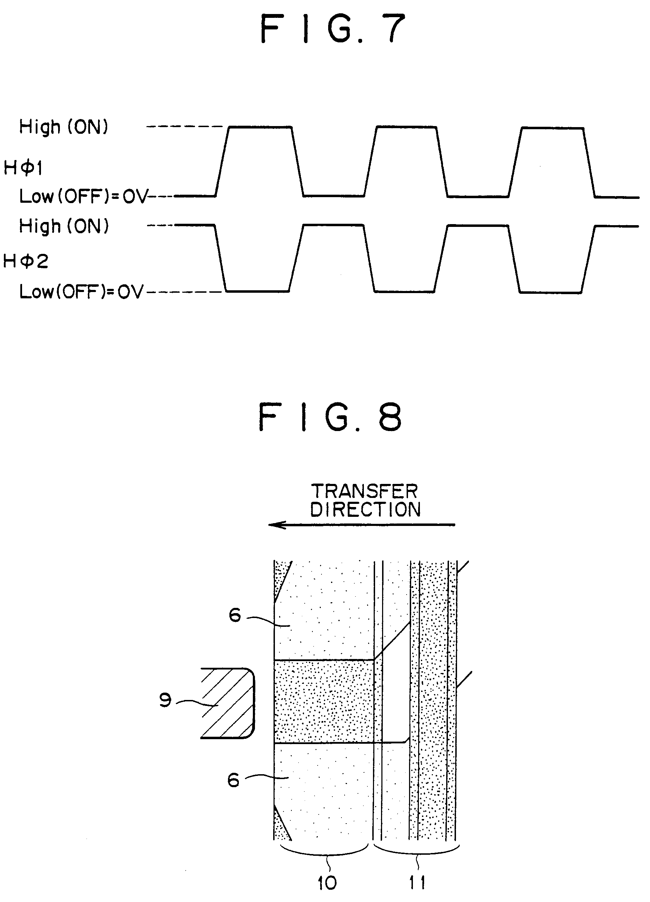

In such a CCD solid-state imaging device, there is made an attempt to form a small signal transfer channel by providing channel barriers in its horizontal transfer register. Fig. 4 is an enlarged plan view of the output part 4e of the horizontal transfer register 4 in the CCD solid-state imaging device; Fig. 5A is a sectional view taken along line B-B' in Fig. 4; Fig. 5B shows a potential profile thereof; Fig. 6A is a sectional view taken along line A-A' in Fig. 4; Fig. 6B shows a potential profile thereof obtained when the gate is in its on-state and off-state; and Fig. 7 shows waveforms of horizontal transfer pulses Hφ1 and Hφ2 used to drive the horizontal transfer register.

Denoted by 6, 6 are channel barriers to form a small signal transfer channel. As shown in Fig. 5, each channel barrier is composed of a P-type semiconductor region formed by selectively implanting a P type impurity into the surface of an N type semiconductor substrate. In the ordinary device, it has been customary heretofore that the channel barriers 6, 6 are formed over the entire length of the horizontal transfer register 4. Reference numeral 26 denotes a small signal transfer channel interposed between the channel barriers 6, 6, and the potentials on both sides of the small signal transfer channel 26 are set to be slightly shallower than the potential in the transfer channel 26 due to the existence of the channel barriers 6, 6, so that the small signal charge can be narrowed down to the small signal transfer channel 26 to be thereby transferred horizontally at a high efficiency. In the ordinary device, the width of the small signal transfer channel 26 (the width in a sectional view of the plane cut in the vertical transfer direction) is substantially equal over the entire length. Fig. 8 is an enlarged plan view of its horizontal signal output gate and the vicinity thereof.

Denoted by 7, 7 are electric fields which generate concentrated flows of signal charges from the channel barriers 6, 6 to the small signal transfer channel 26. There are also shown an outer portion 8 of the horizontal transfer register 4 proximate to the output side beyond the effective pixel region 1, a charge detector 9, and a horizontal signal output gate 10 disposed between the outer portion 8 of the horizontal transfer register 4 and the charge detector 9. This gate 10 is positioned above a floating diffusion area and constitutes a floating diffusion amplifier which, in response to a fixed potential such as 0V for example, serves to keep the floating diffusion at a fixed potential. Denoted by 11 is a horizontal final-stage gate forming the final stage of the horizontal transfer register 4 (8). In response to two-phase horizontal transfer pulses H1, H2 shown in Fig. 7, the gate in each stage of the horizontal transfer register 4 transfers the signal charge horizontally as shown in Fig. 6B.

There are further shown a potential 12 in the floating diffusion area, a potential 13 obtained when the potential in a storage 4s in each stage of the horizontal transfer register 4 is shallow, a potential 14 obtained when the potential in the storage 4s is deep, and a transfer electric field 15 in the floating diffusion area when the final stage potential becomes shallow and the signal charge stored in its storage 4t flows into the charge detector 9 via the floating diffusion area. Denoted by 16 is a potential difference, i.e., dynamic range, between the deep potential in the final stage storage 4s and the potential in the floating diffusion area.

Regarding the principle and method of signal-charge horizontal transfer, there is fundamentally no difference between a structure where a small signal transfer channel 26 is formed by providing channel barriers of low-concentra tion P-type diffusion areas 6, 6 and another structure where such a transfer channel 26 is not formed.

The small signal transfer channel 26 defined by the channel barriers 6, 6 is provided for the following reason. In transferring large signal charge, the horizontal transfer register needs to be formed sufficiently wide, whereas the charge detector 9 needs to be narrow for securing a high sensitivity. However, when the signal charge quantity is small, i.e., in the case of a small signal, it is difficult to efficiently transfer the small-quantity signal charge from the wide horizontal transfer register 4 to the small (narrow) charge detector 9. Therefore, a narrow channel having a slightly deeper potential as compared with any other portion is provided in the horizontal transfer register 4 so that the signal charge can be narrowed down, wherein the small signal charge is efficiently delivered via this channel to the charge detector 9. This narrow channel corresponds to the aforementioned small signal transfer channel 26, and the channel barriers 6, 6 for transferring small signal are used exclusively to form the small signal transfer channel 26.

In the ordinary CCD solid-state imaging device described above, the channel barriers 6, 6 are formed over the entire length of the horizontal transfer register 4, hence raising a program that the charge quantity processible in the horizontal transfer register 4 is reduced. More specifically, due to selective provision of P-type diffusion areas 6, 6 in the horizontal transfer register 4, the small signal transfer channel 26 is formed with its potential being rendered shallow, whereby the processible charge quantity is naturally reduced in proportion to the shallowed value of the potential. And this reduction naturally diminishes the dynamic range of the CCD solid-state imaging device to consequently bring about a non-negligible program.

Further in the ordinary CCD solid-state imaging device, there exists another problem that it is difficult to raise the transfer efficiency under a horizontal signal output gate. An explanation will now be given below on this point with reference to Fig. 6. A horizontal signal output gate 10 serves to control (regulate) transfer of signal charge from an output stage 11 of a horizontal transfer register 4 to a charge detector 9. The horizontal signal output gate 10 is disposed between the output stage 11 of the horizontal transfer register 4 and the charge detector 9, and is given a fixed potential such as 0V for example, wherein the potential in a floating diffusion area under the horizontal signal output gate 10 is set as an exclusive potential separately from the potential on the side of the horizontal transfer register 4. More concretely, the potential in the floating diffusion area is deeper than the shallow potential in the storage 4s of the horizontal transfer register 4 (i.e., the potential in an off-state of the final stage gate), but is shallower than the deep potential therein (i.e., the potential in an on-state of the final stage gate), and the relationship between such potentials determines the transfer efficiency and the dynamic range.

If the potential in the floating diffusion area is set to be shallow, a transfer electric field 15, which is exerted as a motive power to transfer the signal charge from the horizontal transfer register 4 to the charge detector 9, is weakened, whereas if the potential in the floating diffusion area is set to be deep on the contrary, the difference between this potential and the deep potential (in an on-state of the gate) in the storage 4t of the final stage gate is diminished to consequently reduce the dynamic range. Therefore, it is not permitted to set the floating diffusion potential to be deep merely from the viewpoint of raising the transfer efficiency, hence causing restriction to enhancement of the transfer efficiency.

### SUMMARY OF THE INVENTION

The present invention has been accomplished to solve the above problems observed in a CCD solid-state imaging device where channel barriers are provided in a horizontal transfer register for forming a small signal transfer channel. It is an object of the invention to minimize the reduction of a processible charge quantity that may be derived from the existence of such channel barriers. And another object of the invention is to attain enhancement of its transfer efficiency under a horizontal signal output gate.

In the CCD solid-state imaging device of the present invention, a feature resides in the provision of channel barriers only on the output side of a horizontal transfer register beyond its portion corresponding to an effective pixel region of an imaging area.

According to an aspect of the present invention, there is provided a CCD solid-state imaging device comprising at least an imaging area where photo sensors for storing signal charges corresponding to incident light amounts are arrayed two-dimensionally in vertical and horizontal directions and where vertical transfer registers are disposed correspondingly to vertical rows of the photo sensors so as to vertically transfer the signal charges read out from the photo sensors, a horizontal transfer register for horizontally transferring the signal charges transferred thereto from the vertical transfer registers in the imaging area, and a charge detector for detecting the signal charge outputted from the horizontal transfer register via under a horizontal signal output gate, wherein the imaging device further has, in the horizontal transfer register, channel barriers for forming a small signal transfer channel. In this device, the channel barriers are provided only on the output side of the horizontal transfer register beyond its portion corresponding to an effective pixel region of the imaging area. The solid-state imaging device applying this invention may be either an interline type or a frame interline type. And the invention is applicable to both a color CCD solid-state imaging device and a black-and-white one as well.

According to another aspect of the invention, there is provided a solid-state imaging device comprising an imaging area where photo sensors are arrayed for producing signal charges through photoelectric conversion in conformity with incident light amounts, a transfer register for transferring the signal charge read out from the imaging area, and a charge detector for detecting the signal charge outputted via under a signal output gate of the transfer register, wherein channel barriers for forming a small signal transfer channel are provided in the transfer register only in the output-side portion of the transfer register beyond the portion thereof corresponding to the effective pixel region of the imaging area.

Therefore, in the solid-state imaging device of the invention, no channel barrier is existent in the portion corresponding to its effective pixel region, hence causing no reduction of the processible charge quantity that is usually derived from the existence of the channel barriers. Although the channel barriers are existent on the output side beyond the effective pixel region, any resultant reduction of the processible charge quantity can be compensated for by increasing the gate length in the output-side portion of the horizontal transfer register in conformity with narrowing of the small signal transfer channel.

Accordingly, it becomes possible in the CCD solid-state imaging device to avoid a reduction of the processible charge quantity derived from the existence of the channel barriers provided in the horizontal transfer register for forming a small signal transfer channel.

Also in the CCD solid-state imaging device of the invention, the small signal transfer channel formed between the channel barriers may be so shaped that the outer faces thereof extend obliquely outward with approach to the output side under the horizontal signal output gate, whereby the channel is widened toward the output side. In this structure, both lateral portions of the small signal transfer channel extend obliquely outward with approach to the output side under the horizontal signal output gate, so that an outward field vector is newly generated. Therefore, this vector is combined with the primary field vector in the horizontal transfer direction, and the signal charge is transferred by the combined resultant field vector. This resultant field vector is greater in absolute value than the primary field vector in the horizontal transfer direction and acts to transfer the signal charge, so that the signal charge transfer can be executed at a higher efficiency. Consequently, it becomes possible to raise the transfer efficiency in the horizontal signal output gate.

The small signal transfer channel, which is formed by the channel barriers provided only on the output side of the horizontal register beyond the effective pixel region thereof, is widened continuously or stepwise toward the output side so as to deliver the small signal charge efficiently to the charge detector. In this case, it is preferred that the gate length of the horizontal transfer register be increased in conformity with narrowing of the small signal transfer channel. Because, although the processible charge quantity is reduced due to such narrowing of the small signal transfer channel, the reduction can be compensated for by increasing the gate length.

In a modification, the small signal transfer channel formed between the channel barriers may be so shaped that its outer faces extend obliquely outward with approach to the output side under the horizontal signal output gate, whereby the channel width is changed to be greater. In this case, it is possible to enhance the transfer efficiency under the horizontal signal output gate.

The above and other features and advantages of the present invention will become apparent from the following description which will be given with reference to the illustrative accompanying drawings.

### BRIEF DESCRIPTION OF THE DRAWINGS

Fig. 1 is a plan view showing principal components of a first embodiment which represents the CCD solid-state imaging device of the present invention;
Fig. 2 is an enlarged plan view showing a horizontal signal output gate and its vicinity in the embodiment;
Fig. 3 is a plan view schematically showing the structure of the CCD solid-state imaging device;
Fig. 4 is an enlarged plan view of principal components in a ordinary CCD solid-state imaging device;
Figs. 5A and 5B are explanatory diagrams of channel barriers and a small signal transfer channel, in which Fig. 5A is a sectional view taken along line B-B' in Fig. 4, and Fig. 5B shows a potential profile taken along line B-B';
Figs. 6A and 6B are explanatory diagrams illustrating how signal charge is transferred from a horizontal transfer register to a charge detector, in which Fig. 6A is a sectional view taken along line A-A' in Fig. 4, and Fig. 6B shows a potential profile taken along line A-A';
Fig. 7 is a waveform chart of horizontal transfer pulses; and
Fig. 8 is an enlarged plan view showing a horizontal signal output gate and its vicinity in the ordinary example.

### DESCRIPTION OF THE PREFERRED EMBODIMENTS

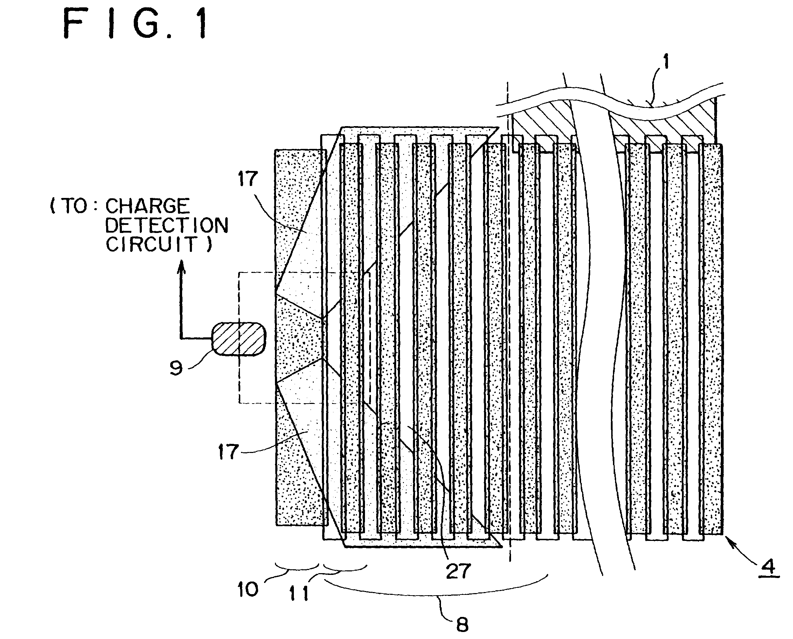

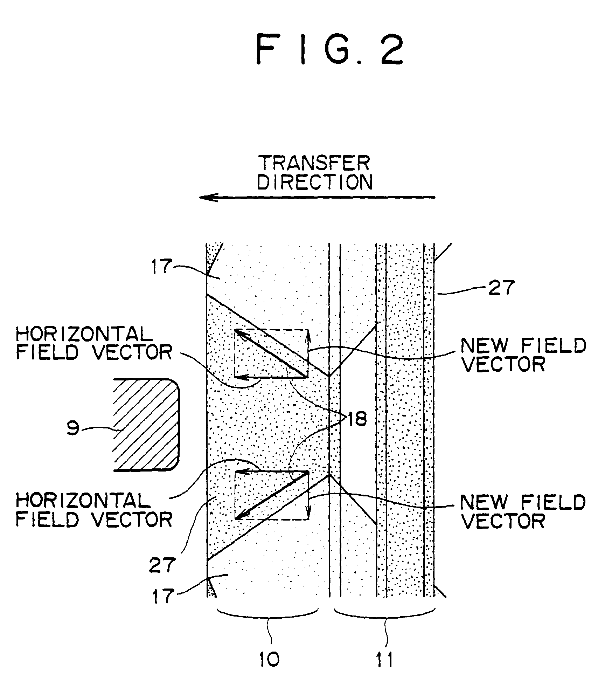

Hereinafter the present invention will be described in detail with reference to its preferred embodiments shown in the accompanying drawings. Fig. 1 is an enlarged plan view showing an output portion of a horizontal transfer register which is a principal component of a first embodiment representing the CCD solid-state imaging device of the present invention, and Fig. 2 is an enlarged plan view showing a horizontal signal output gate and the vicinity thereof. In comparison with the ordinary CCD solid-state imaging device shown in Figs. 4 to 8, this embodiment has some differences as will be described later, while being common therewith in many points. Since the common points have already been explained above, a repeated explanation thereof is omitted here, and a detailed description will be given only on the different points.

In Figs. 1 and 2, reference numerals 17, 17 denote channel barriers provided in a horizontal transfer register 4 for forming a small signal transfer channel, wherein each barrier is composed of a P-type diffusion area as shown in Fig. 5A. Denoted by 27 is a small signal transfer channel formed between the channel barriers 17, 17.

These channel barriers 17, 17 are different from the aforementioned channel barriers 6, 6 in the ordinary CCD solid-state imaging device, in the point that firstly the barriers 17, 17 are formed only on the output side beyond the portion corresponding to an effective pixel region 1. Therefore, the processible charge quantity is not reduced by the channel barriers in the portion corresponding to the effective pixel region 1 of a horizontal transfer register 4.

The space between the channel barriers 17 and 17, i.e., the width of the small signal transfer channel 27, is equal to the width of the horizontal transfer register 4 in the portion most proximate to the transfer source, but becomes narrower toward the output side (toward the transfer destination) up to a horizontal signal output gate 10. Consequently, when the charge quantity is small, the signal charge is transferred horizontally while being narrowed down gradually through the small signal transfer channel 27, whereby the small signal charge can be transferred at a higher efficiency.

In the outer portion of the horizontal transfer register 4 where the channel barriers 17, 17 are provided on the output side beyond the portion corresponding to the effective pixel region 1, although not depicted precisely in the diagram, the gate length is changed to be greater continuously or stepwise in conformity with narrowing of the space between the channel barriers 17, 17 (i.e., the width of the small signal transfer channel 27). Accordingly, the reduction of the processible charge quantity derived from the channel barriers 17, 17 in the outer portion of the horizontal transfer register 4 with the channel barriers 17, 17 can be compensated for by increasing the gate length. Consequently, the small-signal charge transfer efficiency can be raised without reducing the processible charge quantity in the output-side portion of the horizontal transfer register 4.

Thus, according to this CCD solid-state imaging device, it is possible to achieve noticeable enhancement of the charge transfer efficiency due to the small-signal charge channel barriers 17, 17 without causing reduction of the processible charge quantity over the entire length of the horizontal transfer register 4 (i.e., in both of the portion corresponding to the effective pixel region 1 and the output-side portion beyond the effective pixel region 1).

In this CCD solid-state imaging device, as shown in Fig. 2, the inner faces of the channel barriers 17, 17 forming the small signal transfer channel 27 (i.e., the outer faces of the channel 27) extend obliquely outward with approach to the output side under the horizontal signal output gate 10, so that the channel 27 is widened toward the output side. In this structure, it is possible to minimize the reduction of the transfer efficiency under the horizontal signal output gate 10. This point will be explained in detail below.

As described already in connection with Fig. 6, the transfer field 15 is intensified as the potential 12 in the horizontal signal output gate 10 is deepened, hence raising the transfer efficiency between the horizontal transfer register 4 and the charge detector 9. On the other hand, deepening the potential 12 diminishes the difference from the off-time potential in the storage 4s of the final stage 11 of the horizontal signal output gate 10, hence decreasing the dynamic range 16 as a result. It is therefore difficult to raise the transfer efficiency under the horizontal signal output gate 10. However, according to this CCD solid-state imaging device where the inner faces of the channel barriers 17, 17 (i.e., the outer faces of the channel 27) extend obliquely outward with approach to the output side under the horizontal signal output gate 10 to thereby widen the channel 27, an oblique field vector E is generated along each inner face of the channel barriers 17, 17 as shown in Fig. 2.

Thus, the signal charge is transferred by the resultant field vector E which is composed of the primary horizontal transfer field vector and the outward field vector. Naturally, this resultant transfer field vector E is greater in absolute value than the primary horizontal transfer field vector, and the signal charge is transferred by the electric field of a higher intensity than in the ordinary case (where the inner faces of channel barriers 9, 9 extend in the horizontal transfer direction). Consequently, in comparison with such known case, it becomes possible to enhance the transfer efficiency under the horizontal transfer register 10.

Thus, according to the CCD solid-state imaging device of the present invention, channel barriers are provided only on the output side of the horizontal transfer register beyond its portion corresponding to the effective pixel region of the imaging area, so that none of channel barriers is existent in the portion corresponding to the effective pixel region. Consequently, this structure eliminates the reduction of the processible charge quantity that may otherwise be caused by the channel barriers.

Also according to the CCD solid-state imaging device of the invention, the gate length in the portion of the horizontal transfer register having the channel barriers is increased as the space between the channel barriers becomes gradually narrower in the horizontal transfer direction, hence compensating for the reduction of the processible charge quantity derived from narrowing of the small signal transfer channel. In this manner, such compensation is rendered easy for the reason that, although it is not permitted to increase the gate length in the portion corresponding to the effective pixel region due to the rule in forming the imaging area, increase of the gate length is permitted in any portion not corresponding to the effective pixel region.

Therefore, in the CCD solid-state imaging device where channel barriers for forming a small signal transfer channel are provided in the horizontal transfer register, it is possible to avoid any reduction of the processible charge quantity derived from such channel barriers. Consequently, the processible charge quantity can be increased while raising the small-signal charge transfer efficiency of the horizontal transfer register.

And further according to the CCD solid-state imaging device of the invention, the small signal transfer channel formed between the channel barriers is so shaped as to be wider toward the output side as its outer faces extend obliquely outward with approach to the output side under the horizontal signal output gate, whereby an outward field vector is generated as shown in Fig. 2. And the signal charge can be transferred by the resultant field vector produced by combining such outward field vector with the primary field vector in the horizontal transfer direction, hence realizing enhancement of the transfer efficiency under the horizontal signal output gate.

Although the present invention has been described hereinabove with reference to some preferred embodiments thereof, it is to be understood that the invention is not limited to such embodiments alone, and a variety of other changes and modifications will be apparent to those skilled in the art without departing from the spirit of the invention.

The scope of the invention, therefore, is to be determined solely by the appended claims.

## Claims

1. A CCD solid-state imaging device comprising:
at least an paging area where photo sensors for storing signal charges corresponding to incident light amounts are arrayed two-dimensionally in vertical and horizontal directions and where vertical transfer registers are disposed correspondingly to vertical rows of said photo sensors so as to vertically transfer the signal charges read out from said photo sensors;
a horizontal transfer register for horizontally transferring the signal charges transferred thereto from said vertical transfer registers in said imaging area;
a charge detector for detecting the signal charge outputted from said horizontal transfer register via under a horizontal signal output gate; and
channel barriers provided in said horizontal transfer register to form a small signal transfer channel;
wherein said channel barriers are existent only on the output side of said horizontal transfer register beyond its portion corresponding to an effective pixel region of said imaging area.

2. The CCD solid-state imaging device according to claim 1, wherein the gate length in the portion of said horizontal transfer register having the channel barriers is changed to be greater as the space between the channel barriers becomes narrower in the horizontal transfer direction.

3. The CCD solid-state imaging device according to claim 1, wherein the small signal transfer channel formed between the channel barriers is so shaped as to be wider with approach to the output side under the horizontal signal output gate.

4. A solid-state imaging device comprising:
an imaging area where photo sensors are arrayed for producing signal charges through photoelectric conversion in conformity with incident light amounts;
a transfer register for transferring the signal charge read out from said imaging area; and
a charge detector for detecting the signal charge outputted via under a signal output gate from said transfer register;
wherein channel barriers for forming a small signal transfer channel are provided in said transfer register only in the output-side portion of said transfer register beyond the portion thereof corresponding to the effective pixel region of said imaging area.

5. The solid-state imaging device according to claim 4, wherein the gate length in the portion of said transfer register having the channel barriers is increased as the space between said channel barriers becomes narrower in the transfer direction.

6. The solid-state imaging device according to claim 4, wherein said small signal transfer channel formed between the channel barriers is so shaped as to be wider toward the output side under the signal output gate.
